# EUROPÄISCHE PATENTSCHRIFT

(11) **EP 1 739 210 B1**
(45) Veröffentlichungstag und Bekanntmachung des Hinweises auf die Patenterteilung: **07.03.2012**
(21) Anmeldenummer: 06011540.9
(22) Anmeldetag: 02.06.2006
(51) Int. Cl.: C30B 11/00, C30B 11/04, C30B 29/42

(54) **Verfahren zur Herstellung von dotierten Halbleiter-Einkristallen, und III-V-Halbleiter-Einkristall**
Method for production of doped semiconductor single crystal, and III-V semiconductor single crystal
Procédé pour la production d'un monocristal semiconductor dopé, et III-V monocristal semiconductor.

(30) Priorität: 01.07.2005 DE 102005030853; 08.07.2005 US 697860 P
(43) Veröffentlichungstag der Anmeldung: 03.01.2007
(73) Patentinhaber: Freiberger Compound Materials GmbH, 09599 Freiberg (DE)
(72) Erfinder: Kretzer, Ulrich, 09116 Chemnitz (DE); Eichler, Stefan, Dr., 01187 Dresden (DE); Bünger, Thomas, 21335 Lüneburg (DE)
(74) Vertreter: Hofer, Dorothea

(56) Entgegenhaltungen:
- WO-A-2005/007939
- DE-A1-102004 015 863
- US-A1- 2004 187 768
- FORNARI,R.; PAORICI C; ZANOTTI L.; ZUCCALLI G.: "Dislocation-Free Silicon-Doped Galliium Arsenide Grown by LEC Procedure" JOURNAL OF CRYSTAL GROWTH, Bd. 63, 1983, XP002397117 North-Holland
- BASSIGNANA I C ET AL: "Variation in the lattice parameter and crystal quality of commercially available Si-doped GaAs substrates" JOURNAL OF CRYSTAL GROWTH, ELSEVIER, AMSTERDAM, NL, Bd. 178, Nr. 4, Juli 1997 (1997-07), Seiten 445-458, XP004087504 ISSN: 0022-0248
- BUNGER T ET AL: "Development of a vertical gradient freeze process for low EPD GaAs substrates" MATERIALS SCIENCE AND ENGINEERING B, ELSEVIER SEQUOIA, LAUSANNE, CH, Bd. 80, Nr. 1-3, 22. März 2001 (2001-03-22), Seiten 5-9, XP004234652 ISSN: 0921-5107

## Beschreibung

Die Erfindung betrifft ein Verfahren zur Herstellung von mit einem Dotierstoff dotierten Halbleiter-Einkristallen, insbesondere von Verbindungshalbleiter-Einkristallen mit hoher elektrischer Leitfähigkeit vom n- und p-Typ und vor allem vom n-Typ, durch Erstarrung einer Schmelze des Halbleitermaterials in einem Tiegel, unter Verwendung eines Keimkristalls aus dem gleichen Halbleitermaterial wie der herzustellende Halbleiter-Einkristall.

In verschiedenen Bereichen der Halbleitertechnik, insbesondere für die Herstellung von Halbleiterlasern, Lumineszenzdioden und Solarzellen werden Verbindungshalbleiter-Kristalle bzw. -Substratwafer benötigt, deren elektrische Leitfähigkeit innerhalb eines bestimmten, durch die jeweilige Anwendung festgelegten Bereiches liegt. Diese Leitfähigkeit wird durch eine Dotierung mit geeigneten Dotierstoffen erreicht. Durch die Auswahl des Dotierstoffs kann darüber bestimmt werden, ob der Ladungstransport im Halbleiter durch Elektronen oder Defektelektronen dominiert wird. Der Wert der elektrischen Leitfähigkeit wird durch die Konzentration des Dotierstoffs im Halbleiter-Einkristall bestimmt.

Ein übliches Verfahren zur Herstellung von Halbleiter- und speziellen Verbindungshalbleiter-Einkristallen schließt den Schritt ein, daß die Erstarrung der Halbleiterschmelze in einem Tiegel, der z.B. aus Bornitrid gebildet ist, erfolgt, wobei die Halbleiterschmelze von einer Abdeckschmelze, die z.B. aus Boroxid (B₂O₃) gebildet ist, bedeckt sein kann, um ein Abdampfen der flüchtigen Komponente der Halbleiterschmelze zu verhindern. Der Tiegel stellt üblicher Weise einen zylindrischen Behälter dar, der sich in seinem in Betriebsstellung zum unteren Ende hin konisch verjüngt, mit einem sich daran anschließenden zylindrischen Teil geringeren Durchmessers am unteren Ende, der an seiner Unterseite geschlossen sein kann. Der untere zylindrische Teil dient zur Aufnahme eines Keimkristalls. Durch außerhalb des Tiegels angeordnete Heizelemente wird innerhalb des Tiegels ein dreidimensionales, bevorzugt radialsymmetrisches Temperaturfeld aufgeprägt, dessen Symmetrieachse weitgehend mit der Symmetrieachse des Tiegels übereinstimmt. Das Temperaturfeld wird so geformt, daß an jedem Ort innerhalb des Tiegels ein Temperaturgradient mit vertikaler Komponente vorliegt. Während des Kristallzüchtungsprozesses wird das Temperaturfeld so verändert, daß sich die Erstarrungstemperatur-Isotherme ausgehend vom Keimkristall in vertikaler Richtung verschiebt. Eine gute Kontrollierbarkeit des Kristallzüchtungsprozesses ist dann gegeben, wenn die Erstarrungsfront, d.h. die Phasengrenze zwischen Kristall und Halbleiterschmelze über den gesamten Querschnitt des Tiegels und zu jedem Prozeßzeitpunkt nur wenig von der Erstarrungstemperatur-Isothermen abweicht.

Die Dotierung im herkömmlichen Herstellungsverfahren für Halbleiter- und speziell Verbindungshalbleiter-Einkristalle erfolgt dadurch, daß der Dotierstoff vor oder nach dem Aufschmelzen des Halbleitermaterials in elementarer oder chemisch gebundener Form in den Tiegel zugegeben wird, und anschließend der Prozeß des Einkristallwachstums durch Erstarrung des geschmolzenen Halbleitermaterials durchgeführt wird. In einer speziellen, zum LEC-Verfahren durchgeführten Arbeit von Fornari et al. (Journal of Crystal Growth 63 (1983), 415-418) zu Si-dotiertem GaAs-Einkristall wurde dementsprechend die Menge des Dotierstoffs Silizium, die der gewünschten Dotierstoffkonzentration entsprach, in der Schmelze vorgelegt (2,5 x 10¹⁹ Atome/cm³), wonach im Verlauf des weiteren Kristallwachstums sich Silizium in der Schmelze allmählich bis zum Erreichen einer geeigneten Konzentration von 3 x 10¹⁹ Atome/cm³ in der Schmelze anreicherte. Bei Fornari et al. sollte dem Problem der Bildung von festen Teilchen in der Schmelze begegnet werden, die auf der GaAs-Schmelze aufschwimmen können und somit speziell beim LEC-Prozeß, bei dem der Kristall aus der Schmelze gezogen wird, bei Kontakt mit der Phasengrenze zwischen Kristall und Schmelze zu Störung des einkristallinen Wachstums führen kann. Dieses Phänomen wird beim VGF-Verfahren jedoch nicht zum Problem, da die Phasengrenze zwischen Kristall und Schmelze keinen Kontakt zur Schmelzoberfläche hat.

Die Menge des vorgelegten Dotierstoffs in herkömmlichen Verfahren wird so bemessen, daß sich in der Schmelze eine Dotierstoffkonzentration einstellt, die unter Berücksichtigung des effektiven Verteilungskoeffizienten zu einem Einbau des Dotierstoffs in den Einkristall in der gewünschten Konzentration führt. Zur Erzielung einer hohen Leitfähigkeit ist der Schmelze eine große Menge des Dotierstoffs zugegeben.
Bei der Verwendung einer Abdeckschmelze mit z.B. einer Boroxidschmelze steht die Halbleiterschmelze während der gesamten Dauer des Kristallzüchtungsprozesses in unmittelbaren Kontakt zur dieser Schmelze. In Abhängigkeit der Affinität des verwendeten Dotierstoffs zu Sauerstoff findet eine teilweise Oxidation des Dotierstoffs und eine Lösung des Oxids in der Boroxidschmelze statt. Dadurch wird der Halbleiterschmelze ein Teil des Dotierstoffs entzogen. Gleichzeitig wird die bei der Reaktion freiwerdende Verunreinigung (im genannten Beispiel Bor) in die Halbleiterschmelze eingetragen. Die hergestellten Kristalle können dadurch mit einer erheblichen Konzentration an dieser Verunreinigung (z.B. Bor) verunreinigt sein, wodurch sich ihre Qualität verschlechtert. Beispielsweise kann eine Verunreinigung mit Bor zur Ausbildung von elektrisch kompensierenden Defekten und dadurch zu einer Verminderung der elektrischen Leitfähigkeit führen.

In JP 2000-109400A [1], JP2004-217508A [2] und JP10-279398A [3] werden Verfahren beschrieben, mit denen eine Vergleichmäßigung eines Silizium-Einbaus in einen Galliumarsenid-Einkristall erreicht werden soll. Dadurch verbessert sich die axiale Homogenität der elektrischen Leitfähigkeit des Einkristalls. Die Verfahren basieren auf dem Umrühren einer Boroxid-Abdeckschmelze zu einem bestimmten Zeitpunkt oder zu mehreren Zeitpunkten des Kristallzüchtungsprozesses. Bei den in [2] und [3] beschriebenen Verfahren wird eine Boroxid-Abdeckschmelze verwendet, die mit SiO₂ angereichert wurde, um eine Oxidation des in der Galliumarsenid-Schmelze enthaltenen Dotierstoffs Silizium zu unterdrücken. Maßgebend für das Reaktionsgleichgewicht zwischen Silizium, Boroxid und SiO₂ ist dessen Konzentration im Boroxid an der Phasengrenze zur Galliumarsenid-Schmelze. Das Umrühren der Boroxid-Abdeckschmelze führt zu ihrer Durchmischung und damit zu einer Verminderung der SiO₂-Konzentration an der Phasengrenze zur Galliumarsenid-Schmelze. Dadurch wird die Oxidation von in der Galliumarsenid-Schmelze enthaltenen Siliziums befördert und die Siliziumkonzentration im Galliumarsenid-Einkristall steigt zu dessen Ende hin nicht so stark an wie ohne diese Maßnahme. Durch die Oxidation des Siliziums durch das Boroxid wird jedoch die Konzentration der Borverunreinigung in der Galliumarsenidschmelze und im Galliumarsenid-Einkristall erhöht.

Die in [1], [2] und [3] beschriebenen Verfahren ermöglichen zwar eine gewisse Vergleichmäßigung des Silizium-Einbaus in einen Galliumarsenid-Einkristall, jedoch wird dabei die Konzentration der Borverunreinigung in der Galliumarsenidschmelze und im Galliumarsenid-Einkristall erhöht. Dies wirkt sich nachteilig auf die Qualität der erzeugten Kristalle aus. Bei einem in JP2004-115339A [4] beschriebenen Verfahren wird bei der Herstellung eines Galliumarsenid-Einkristalls die Galliumarsenid-Schmelze durch eine Isolationsschicht aus flüssigem Borarsenid von der Boroxid-Abdeckschmelze getrennt. Dadurch wird die Oxidation des Dotierstoffs Silizium unterdrückt.

Die US 2004/0187768 A1 verfolgt ein anderes Konzept zur Herstellung dotierter GaAs-Kristalle vom p-Typ mit einer sehr geringen Versetzungsdichte von < 100 cm⁻². Die geringe Versetzungsdichte soll erreicht werden, indem zwingend 4 Arten von wDotiermitteln zu dem GaAs-Ausgangsmaterial zugegeben werden, nämlich als Dotiermittel Zn vom p-Typ, Si vom n-Typ, B als neutrales Atom sowie In als neutrales Atom. Das heißt, eine hohe Leitfähigkeit vom p-Typ wird durch die Dotierung mit Zink erreicht, während die weiteren Verunreinigungen Si, B und In zu einem Verunreinigungshärtungseffekt führen sollen. Die Notwendigkeit der bewußten Dotierung der 4 Dotierarten Zn, Si, B für GaAs-Kristalle vom p-Typ schränkt die Anwendbarkeit solcher Wafermaterialien stark ein.

Die US 3,496,118 beschreibt ein Verfahren zur Erhöhung der elektrischen Leitfähigkeit von III-V-Halbleiterverbindungen, bei dem eine Schmelze der III-V-Halbleiterverbindung in Gegenwart einer Verunreinigung, die aus Al, Sb, Bi, In und Pb ausgewählt ist, erzeugt wird und bei dem ein Kristall bei einem Erstarrungspunkt gebildet wird, der bewußt durch die zugegebene Verunreinigung abgesenkt wird. Als Leitfähigkeit erzeugende Verunreinigungen werden Dotieratome zugegeben, die aus Mn, Te, Se, S, Cd, Zn, Sn, Ge und Si ausgewählt sind. Die Zugabemenge der Verunreinigung zur Unterkühlung der Schmelze ist so hoch, daß nicht mehr von einer Dotierung gesprochen werden kann und kein binärer III-V-Einkristall gebildet wird, sondern daß eine III-V-Mehrkomponenten-Schmelze und ein entsprechender Kristall (ternär, quaternär) erzeugt wird.

Um den Bedarf nach III-V-Haibleiterelnkristallen mit einer erwünscht hohen Ladungsträgerbeweglichkeit der Dotierung zu erfüllen, wurde die herkömmliche Herstellung üblicherweise ohne Abdeckschmelze von z.B. B₂O₃ in einem Schiffchen zur horizontalen Erstarrung der Halbleiter-Schmelze ausgeführt. Dieses Herstellungsprinzip ist jedoch nur auf die Herstellung von III-V-Halbleitereinkristallen mit kleinem Durchmesser wie normalerweise 50 mm (2 Inch) oder bis maximal 75 mm (3 Inch) anwendbar. Die KR 1019920010134 B1 zum Beispiel beschreibt ein Bridgeman-Verfahren, bei dem die Erstarrung der GaAs-Schmelze ohne Boroxid-Abdeckschmelze in einer abgeschlossenen Quarzglasampulle erfolgt. Ein durch dieses Verfahren hergestellter GaAs-Einkristall besitzt eine Elektronenmobilität von 2000 bis 4000 cm/Vs und eine Elektronenkonzentration von 10¹⁷-10¹⁸ cm⁻³.
Wollte man herkömmlich III-V-Halbleitereinkristalle mit größeren Durchmessern, und insbesondere bei großen Durchmessern von mindestens 100 mm auf der Basis einer vertikal gerichteten Erstarrung einer Schmelze des Halbleitermaterials herstellen, musste eine Abdeckschmelze von z.B. Boroxid verwendet werden, was aber zu den beschriebenen Problemen führt.

Mit den bekannten Verfahren gelingt es nicht, Halbleiter-Einkristalle mit einer hohen elektrischen Leitfähigkeit bei gleichzeitig hoher Prozeßsicherheit, Ausbeute und Qualität herzustellen.

Die Veröffentlichung von Th. Bünger et al. in Materials Science and Engineering B 80, S. 5-9 (2001) offenbart GaAs-Einkristalle mit Durchmesser von 100 mm (48nch), die in einem ä4$# VGF-Verfahren mit B₂O₃-Abdeckschmelze kristallisiert wurden. Einzelne Wafer konnten eine maximale Trägerkonzentration von etwa 3,5×10¹⁸ erreichen, wobei eine Hallbeweglichkeit von ungefähr 1.500 cm²/Vs erhalten wurde.

Aufgabe der Erfindung ist es, ein Verfahren zur Herstellung von dotierten Halbleiter-Einkristallen, insbesondere solche von III-V-Halbleiterverbindungen, bereitzustellen, mit dem eine hohe elektrische Leitfähigkeit bei gleichzeitig begrenzter Verunreinigung durch eine z.B. aus der Abdeckschmelze stammenden Verunreinigung wie Bor ermöglicht wird, und wobei gleichzeitig die Produktqualität, die Prozeßsicherheit und die Ausbeute erhöht und damit die Ökonomie des Prozesses verbessert werden können.

Die Aufgabe wird durch das Verfahren gemäß Patentanspruch 1 und durch einen III-V-Halbleiter-Einkristall-Ingot gemäß Patentanspruch 13 bzw. Substratwafer gemäß Patentanspruch 22 gelöst. Weiterbildungen der Erfindung sind in den Unteransprüchen angegeben.

Ein Grund der Nachteile von herkömmlichen Verfahren zur Herstellung von Halbleiter-Einkristallen, insbesondere solchen zur Herstellung von III-V-Verbindungshalbleiter-Einkristallen hoher elektrischer Leitfähigkeit wie z.B. den in [1] - [4] beschriebenen oder ähnlichen Verfahren, wird in der Gegenwart des Dotierstoffs wie Silizium und einer damit verbundenen erhöhten Unterkühlung der Schmelze vermutet. Erreicht die Konzentration des Dotierstoffs in der Schmelze einen bestimmten Bereich, so werden wesentliche physikalische Eigenschaften der Schmelze in einer Weise beeinflußt, daß sie sich ungünstig auf die Kontrollierbarkeit von kritischen Prozeßstufen des Kristallzüchtungsprozesses auswirken. Daraus können sich größere, mehr oder weniger zufällige Abweichungen zwischen Erstarrungstemperatur-Isothermen und Phasengrenze ergeben, wodurch die Kontrollierbarkeit des Kristallzüchtungsprozesses deutlich verschlechtert wird. Eine besondere Gefahr stellen solche Abweichungen beim Prozeß des Anwachsens an den Keimkristall und bei der Erstarrung im konischen Bereich des Tiegels dar. Fehlkeimbildungen oder Zwillingswachstum in diesen Abschnitten des Kristallzüchtungsprozesses setzen sich im weiter wachsenden Kristall fort. Ferner kann es zu erheblichen Einbußen an nutzbarer Kristallänge kommen, was sich negativ auf die Ausbeute und damit die Ökonomie des Kristallzüchtungsprozesses auswirkt. Zudem ist bei der Verwendung einer Abdeckschmelze die Beimengung von Dotierstoff und der Eintrag von Verunreinigung ein gleichläufiger Prozeß. Je höher die gewünschte Konzentration des Dotierstoffs gewählt wird, desto größer ist die Gefahr des Eintrags der Verunreinigung. In den herkömmlich hergestellten Halbleiter-Einkristallen und den daraus gefertigten Substratwafern war es daher nicht möglich, eine hohe Dotierstoffkonzentration wie z.B. von Silizium und den daraus resultierenden Eigenschaften einer relativ hohen elektrischen Leitfähigkeit und/oder eines relativ niedrigen elektrischen Widerstands mit einer relativ verringerten Verunreinigungskonzentration wie z.B. von Bor zu kombinieren.
Eine Unterkühlung der Schmelze während des Wachstums im Kristallkonus kann durch die Vermessung der Facettenlängen auf dem Kristall festgestellt werden. Bei hoher Dotierstoffkonzentration kann es in Verbindungshalbleitem zur asymmetrischen Ausbildung der Facetten kommen, d.h. die Unterkühlung ist abhängig von der Natur der facettierten Wachstumsflächen. Wegen des Beitrages der Unterkühlung der Schmelze kann in hoch Silizium-dotierten Galliumarsenid-Einkristallen diese Asymmetrie der Facettenlängen Ga/As bis zu einem Verhältnis von 2:1 betragen. Die Unterkühlung beträgt in diesem Fall einige Grad Kelvin.
Das erfindungsgemäße Verfahren hat den Vorteil, daß die Unterkühlung der Halbleiterschmelze in den kritischen Prozeßabschnitten des Ankeimens an den Keimkristall und der Erstarrung im konischen Bereich des Tiegels deutlich verringert wird. Dadurch wird die Kontrollierbarkeit des Kristallzüchtungsprozesses in diesen Prozeßabschnitten verbessert und die Wahrscheinlichkeit des Auftretens von Störungen des Einkristallwachstums deutlich verringert. Ein weiterer Vorteil besteht in der Verkürzung des Zeitraums, der für die Oxidation des Dotierstoffs durch den in der Abdeckschmelze wie Boroxid enthaltenen Sauerstoff zur Verfügung steht. Dadurch werden die Verluste an Dotierstoff und der Eintrag von Verunreinigungen aus der Abdeckschmelze wie Bor in die Halbleiterschmelze verringert. Die hergestellten Kristalle enthalten bei gegebener vorbestimmter Dotierstoffkonzentration eine deutlich geringere Konzentration an Verunreinigungen wie Bor, die aus dem Abdeckmaterial stammt. Durch das erfindungsgemäße Verfahren werden die Prozeßsicherheit und Ausbeute und damit die Ökonomie des Prozesses sowie die Qualität und die Eigenschaften der Einkristalle signifikant verbessert.

Im Ergebnis erhält der hergestellte Halbleiter-Einkristall im später (zum Erzeugen eines Substratwafers) weiter genutzten zylindrischen Bereich des erstarrten Ingots eine gewünschte und voreinstellbare elektrische Leitfähigkeit aufgrund der kontrollierten Zugabe des Dotierstoffs bei gleichzeitig verringertem Eintrag von unerwünschten Verunreinigungen. Je erstarrtem Anteil des Ingots, d.h. dem Volumenbereich zur nachfolgenden Erzeugung des Substratwafers, ist wegen geringerer Probleme und Defekte durch die erfindungsgemäße Arbeitsweise, eine gegenüber dem Stand der Technik deutlich verbessertes Verhältnis von hoher Dotierung (entsprechend hoher Leitfähigkeit) zu niedriger Verunreinigung realisierbar. Dadurch kann in einer besonderen Ausführungsform gemäß Anspruch 13 ein III-V-Halbleiter-Einkristall vom n-Typ bereitgestellt werden, der bei einer ausreichenden Menge von Leitfähigkeit erzeugendem Dotierstoff wie Si und bei einer gleichzeitigen Begrenzung einer herstellungsbedingt vorliegenden Verunreinigung eine einzigartige Kombination von elektrischer Leitfähigkeit und spezifischem elektrischem Widerstand erhalten werden kann. Mit dem Ausdruck "herstellungsbedingt vorliegenden Verunreinigung" ist in dieser Ausführungsform gemeint, daß dieser Verunreinigungstyp nicht bewußt, z.B. zur Einstellung einer Leitfähigkeit oder zur Beeinflussung einer Versetzungsdichte, als Dotiermittel mit in den Tiegel zu dem III-V-Halbleiter-Ausgangsmaterial eingebracht wird, sondern daß er unvermeidbar durch die Art der Herstellung in den III-V-Halbleiter-Einkristall eingebracht wurde, wie Bor aufgrund einer zur Herstellung großer Wafer von mindestens 100mm Durchmesser mit sehr guten Eigenschaften notwendigen Abdeckschmelze. Diese Ausführungsform dient daher insbesondere zur Bereitstellung von III-V-Halbleiter-Einkristallen, die einen Durchmesser von mindestens 100mm aufweisen, und vor allem solche, die vom n-Typ sind.

Durch erfindungsgemäß erhältliche, deutlich verbesserte Verhältnis von hoher Dotierung (entsprechend hoher Leitfähigkeit) zu niedriger Verunreinigung läßt sich ferner bei III-V-Halbleiter-Einkristallen sogar mit großem Durchmesser von mindestens 100 mm und den entsprechend daraus hergestellten Wafern überraschend großen Beweglichkeiten der Ladungsträgerkonzentration (bestimmt nach der gemäß Standard F76-86 meßbaren Hallbeweglichkeit) realisieren. Dies führt zu der im Anspruch 17 festgelegten besonderen Ausführungsform der Erfindung.

Durch die Kontrolle des zur Einstellung der elektrischen Leitfähigkeit verwendeten Dotierstoffs und durch Minimierung von anderen, herstellungsbedingt vorliegenden Verunreinigungen wird erfindungsgemäß eine ausgezeichnete Kristallqualität von binären III-V-Einkristallen erhalten, die zudem eine einzigartige Kombination von Leitfähigkeit, Ladungsträgerkonzentration und Ladungsträgerbeweglichkeit aufweisen.

Erfindungsgemäß braucht nicht die gesamte Menge des Dotierstoffs, die zur Einstellung einer gewünschten, vorbestimmten elektrischen Leitfähigkeit gewählt wird, gemäß (a) oder (b) des Anspruchs 1 zugegeben zu werden, sondern das Einbringen dieser Gesamtmenge kann alternativ in mindestens zwei Stufen erfolgen, von denen nur ein Schritt die Bedingung (a) oder (b) erfüllt. Das heißt es kann eine geringere Menge des Dotierstoffs, die zur Vermeidung wesentlicher Nachteile noch toleriert wird, vorab bzw. vorläufig in den Tiegel gegeben werden, d.h. bevor mit der Erstarrung der Halbleiterschmelze begonnen wird. Beim Arbeiten nach einem herkömmlichen Verfahren durfte eine vorab bestimmte Konzentration des Dotierstoffs vor Beginn des Kristallzüchtungs- bzw. -wachstumsprozesses nicht überschritten werden, ohne Nachteile wie Störungen des Einkristallwachstums zu erhalten. Zum Beispiel bei der Herstellung von Silizium-dotierten Galliumarsenid-Einkristallen beträgt z.B. die maximale anfängliche Siliziumkonzentration in der Galliumarsenidschmelze, die zur Vermeidung deutlicher Nachteile noch tolerierbar ist, etwa 4×10¹⁸ Atome/cm³ (entsprechend 5.6×10¹⁷ Atome/cm³ im erstarrten Kristall). Bei dieser Ausführungsform des erfindungsgemäßen Verfahrens wird in einem ersten Schritt die kritische Phase des Ankeimens und der Kristallbildung im konischen Bereich unter kontrollierten Bedingungen bei geringer bzw. unkritischer Dotierstoffkonzentration ermöglicht, z.B. bei maximal etwa 4×10¹⁸ Atome/cm³ der Schmelze (entsprechend 5.6×10¹⁷ Atome/cm³ im erstarrten Kristall), während im zweiten Schritt für den zylindrischen Hauptbereich des Tiegels, d.h. der später zur Substratwaferherstellung genutzte Bereich, die eigentlich zur Anwendung gewünschte und vordefinierbare höhere Dotierstoffkonzentration gewählt wird, z.B. bei mindestens etwa 4×10¹⁸ Atome/cm³ der Schmelze (entsprechend 5.6×10¹⁷ Atome/cm³ im erstarrten Kristall) und wahlweise bzw. bevorzugt darüber. Im Anspruch 2 sind geeignete Vorabeinstellungen der Dotierstoffkonzentration für den ersten Schritt angegeben, jedoch ist das Prinzip der dieser Ausführungsform nicht darauf beschränkt. Zum Beispiel kann eine Dotierstoffzugabe im ersten Schritt so gewählt werden, daß sich im konischen Bereich eine zum zylindrischen Bereich des Tiegels hin steigende Dotierstoffkonzentration und/oder ein gleichmäßiger Übergang der Dotierstoffkonzentration vom konischen zum zylindrischen Bereich ergibt.

Je nach beschriebener Verfahrensweise sind die Merkmale des Anspruchs 4, einzeln oder in Kombination, realisierbar.

Die Verwendung einer Abdeckschmelze gemäß Anspruch 5 erlaubt eine Verhinderung des Abdampfens flüchtiger Komponenten aus der Halbleiterschmelze und gleichzeitig eine ökonomische Arbeitsweise. Geeignete Materialien für die Abdeckschmelze sind Boroxid, Borarsenid und Siliziumdioxid und Kombinationen davon. Das bevorzugte Material, insbesondere zum Abdecken einer III-V-Halbleiterschmelze, ist Boroxid. Mit der Erfindung ist es möglich, die aus der Abdeckschmelze stammende Verunreinigung, z.B. das Bor, deutlich zu begrenzen, selbst wenn eine hohe Dotierstoffkonzentration gewünscht wird.
Der Nutzen der Erfindung ist besonders ausgeprägt bei Herstellung von Verbindungshalbleiter-Einkristallen und gegebenenfalls daraus gefertigten Substratwafern, wie sie in den Ansprüchen 7 bis 10 definiert sind. Die erfindungsgemäß hergestellten Einkristalle umfassen als Hauptbestandteile bevorzugt III-V-Halbleiterverbindungen wie GaAs, InP, GaP, InAs, GaSb, InSb oder andere Halbleiterverbindungen wie SiGe, HgCdTe, HgZnTe, ZnO, oder bestehen aus den genannten III-V-Halbleiterverbindungen. Ein besonders bevorzugtes Halbleiter-Einkristallmaterial ist GaAs.

Der primär zur Einstellung der elektrischen Leitfähigkeit gewählte Dotierstoff wird geeigneterweise in fester Form zugegeben. Ein im Beispiel von GaAs zum Erzeugen einer hohen Leitfähigkeit besonders geeigneter Dotierstoff ist Silizium (Si), aber auch Tellur (Te), Schwefel (S), Zink (Zn) und Selen (Se) alleine oder in Kombination, jeweils in elementarer oder chemisch gebundener Form. Die Bereitstellung von III-V-Halbleiter-Einkristallen vom n-Typ ist besonders bevorzugt, und Si ist ein bevorzugtes Dotiermittel. Da hier kompensierende Bor-Defekte kritisch sind, ist die Borkonzentration durch Verwendung des erfindungsgemäßen Verfahrens so gering wie möglich zu halten und auf das herstellungsbedingt unvermeidbare Maß zu begrenzen. Indium (In) sollte nicht als Dotierstoff zugegeben werden. Auch ist die Zugabemenge eines Dotierstoffs zur Einstellung einer gewünschten Leitfähigkeit ausreichend. Auf diese Weise werden nur binäre III-V-Halbleiter-Einkristalle und vorzugsweise binärer GaAs-Einkristall gebildet.

Das erfindungsgemäße Verfahren kann bei allen Verfahren zur Herstellung von dotierten Halbleiter-Einkristallen aus einer Halbleiterschmelze angewandt werden. Wie aus der Erläuterung oben deutlich wird, kann sich die erfindungsgemäße Wirkungsweise besonders dann entfalten, wenn eine gerichtete Erstarrung des Halbleiter-Einkristalls direkt in der Schmelze von unten nach oben erfolgt. Das erfindungsgemäße Verfahren ist daher besonders gut auf die Technik des VGF-(Vertical Gradient Freeze-) oder des VB-(Vertical Boat- bzw. Vertical Bridgeman-) Verfahrens anwendbar. Dadurch können erfindungsgemäß ferner sehr geringe Versetzungsdichten im hergesellten III-V-Halbleiter-Einkristall bzw. -Substrat, die bevorzugt im Bereich von höchstens 5 × 10² cm⁻² liegen, erhalten werden.

Somit lassen sich mit der erfindungsgemäßen Technik III-V-Halbleiter-Einkristalle realisieren, wie sie im Anspruch 13 und im Anspruch 17 sowie in den bevorzugten Weiterbildungen der jeweiligen Unteransprüche definiert sind.
Substratwafer gemäß Anspruch 22 lassen sich aus diesem erfindungsgemäßen III-V-Halbleiter-Einkristall-Ingot bilden, z.B. durch Sägen oder anderweitigen Schneiden des Einkristall-Ingots. Der jeweilige Substratwafer bildet dabei die Verhältnisse hinsichtlich Dotierstoffkonzentration, Verunreinigungskonzentration, spezifische elektrische Leitfähigkeit und spezifischer elektrischer Widerstand bezogen auf den diesbezüglich erstarrten Anteil (g) in Längsrichtung des Kristalls ab.

Erfindungsgemäß ist es möglich und auch bevorzugt, daß die in den Ansprüchen 13 und 17 sowie in den jeweiligen Weiterbildungen der Unteransprüche angegebenen Bedingungen im gesamten zylindrischen Bereich des III-V-Halbleiter-Einkristalls, d.h. über den gesamten erstarrten Anteil g des zylindrischen Kristall-Ingots, vorliegt, und daß diese Bedingungen entsprechend in allen aus diesem III-V-Halbleiter-Einkristall bzw. -Ingot hergestellten Substratwafern vorliegen.

Das erfindungsgemäße Konzept ist besonders vorteilhaft auf größere Einkristall- und Substratwaferdurchmesser von mindestens 100 mm, bevorzugt von mindestens 150mm und von mindestens 200 mm anwendbar, d.h. für Durchmesser, bei denen mit herkömmlicher Technik die erfindungsgemäß Kombination von elektrischer Leitfähigkeit und spezifischem elektrischem Widerstand und die gleichzeitige Einstellung der Ladungsträgerkonzentration und der Ladungsträgerbeweglichkeit der Erfindung nicht erreicht wurden. Für solche großen Durchmesser wird erfindungsgemäß das VGF- oder das VB-Verfahren zur Kristallherstellung verwendet, und es wird eine Abdeckschmelze von z.B. Boroxid verwendet.

Weitere Merkmale und Vorteile der Erfindung ergeben sich aus der Beschreibung von nicht einschränkenden Ausführungsformen unter Berücksichtigung der beigefügten Fig. 1 bis Fig. 6.
Fig. 1 zeigt einen schematischen Querschnitt durch eine Vorrichtung zur Züchtung von Verbindungshalbleiter-Einkristallen.
Fig. 2 zeigt für das Beispiel eines Silizium-dotierten Galliumarsenid-Einkristalls den axialen Verlauf der Siliziumkonzentration in einem gemäß der Erfindung hergestellten Einkristall im Vergleich zu einem nach herkömmlichem Verfahren hergestellten Einkristall.
Fig. 3 zeigt entsprechend den axialen Verlauf der Borkonzentration im jeweils gleichen, in Fig. 2 dargestellten Silizium-dotierten Galliumarsenid-Einkristalls gemäß der Erfindung einerseits und im Vergleichsbeispiel andererseits.
Fig. 4 zeigt einen dementsprechenden Vergleich des axialen Verlaufs der Ladungsträgerkonzentration jeweils des erfindungsgemäßen Beispiels und des Vergleichsbeispiels von Fig. 2.
Fig. 5 zeigt einen dementsprechenden Vergleich des axialen Verlaufs des spezifischen elektrischen Widerstands jeweils des erfindungsgemäßen Beispiels und des Vergleichsbeispiels von Fig. 2.
Fig. 6 zeigt einen dementsprechenden Vergleich des axialen Verlaufs der spezifischen elektrischen Leitfähigkeit jeweils des erfindungsgemäßen Beispiels und des Vergleichsbeispiels von Fig. 2.
Fig. 7 zeigt einen Vergleich zwischen der experimentell ermittelten Abhängigkeit der Hallbeweglichkeit von der Ladungsträgerkonzentration zwischen einem gemäß der Erfindung hergestellten Einkristall und einem nach herkömmlichem Verfahren hergestellten Einkristall.

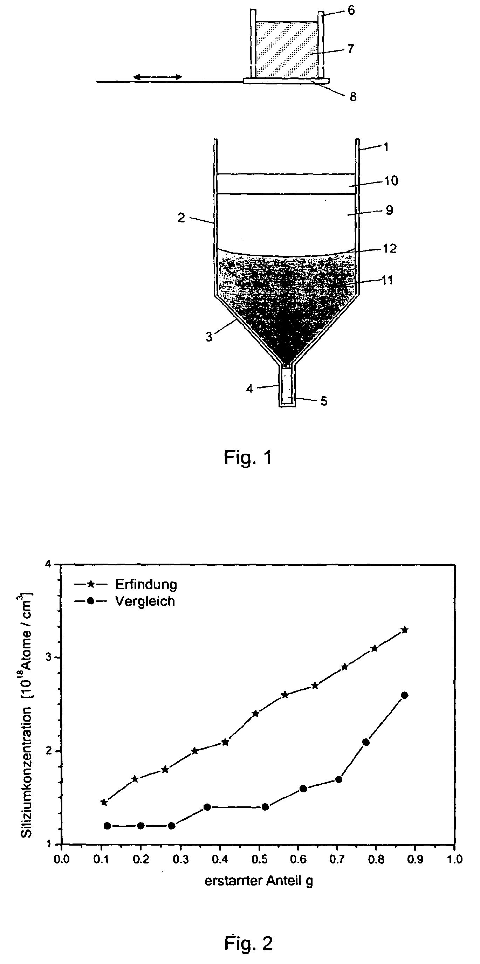

Wie aus Fig. 1 ersichtlich ist, weist die Vorrichtung zur Züchtung von Verbindungshalbleiter-Einkristallen einen Tiegel 1 auf, der z.B. aus Bornitrid und insbesondere aus pBN gebildet ist. Der Tiegel weist einen zylindrischen Abschnitt 2, einen sich an seinem in Betriebsstellung unteren Ende konisch verjüngenden Abschnitt 3 sowie einen daran anschließenden, unteren zylindrischen Abschnitt 4 geringeren Durchmessers, der an seiner Unterseite geschlossen sein kann, auf. Der zylindrische Abschnitt 4 dient zur Aufnahme eines Keimkristalls 5.

Der Tiegel 1 ist in an sich bekannter Weise in einem in Fig. 1 nicht dargestellten Ofen angeordnet. Der Ofen weist in bekannter Weise Heizelemente zum Erzeugen eines dreidimensionalen Temperaturfeldes mit einem vertikalen Temperaturgradienten auf. Es ist eine nicht dargestellte Steuerung vorgesehen, die so ausgebildet ist, daß die Heizelemente derart betrieben werden können, daß das im festen Zustand in den Tiegel 1 eingefüllte Halbleitermaterial aufgeschmolzen wird und die Halbleiterschmelze anschließend am Keimkristall 5 beginnend kontinuierlich bis zum oberen Rand des Tiegels 1 erstarrt. Oberhalb des Tiegels befindet sich ein Behälter 6, der eine bestimmte Menge eines Dotierstoffs 7 enthält. Der Behälter kann mit einer Einrichtung 8 auf seiner Unterseite geöffnet werden, so daß der darin befindliche Dotierstoff 7 in den Tiegel 1 fällt.

Beim erfindungsgemäßen Verfahren wird zuerst ein Keimkristall 5, bestehend aus dem gleichen Halbleiterwerkstoff wie der herzustellende Kristall, in den unteren zylindrischen Abschnitt 4 des Tiegels 1 gegeben. Dann werden in den Tiegel 1 das Halbleitermaterial, z.B. GaAs oder eine andere bevorzugte III-V-Halbleiterverbindung, und das Material für die Abdeckschmelze, z.B. Boroxid, jeweils in festem Zustand eingefüllt. Das in den Tiegel 1 eingefüllte Halbleitermaterial kann bereits eine geringe Menge des Dotierstoffs in Form einer Dotierung enthalten, die während der Erzeugung dieses Halbleitermaterials zugegeben wurde. Alternativ oder zusätzlich kann in den Tiegel 1 vorläufig ein Dotierstoff in einer geringen Menge zugesetzt werden, daß die sich in der Halbleiterschmelze einstellende Dotierstoffkonzentration noch nicht zu einer deutlichen Verstärkung der konstitutionellen Anteils an der Unterkühlung der Halbleiterschmelze führt. Der mittels der Einrichtung 8 auf der Unterseite verschlossene Behälter 6 wird mit einer bestimmten Menge des Dotierstoffs 7 in fester Form gefüllt. Die Heizelemente werden derart angesteuert, daß das Halbleitermaterial und das Abdeckmaterial (Boroxid) vollständig aufschmelzen. Aufgrund des Dichteunterschieds befindet sich die Halbleiterschmelze 9 im unteren Teil des Tiegels und wird von der Abdeckschmelze 10 (Boroxid) vollständig bedeckt. Die Heizelemente werden sodann derart angesteuert, daß sich ein vertikaler Temperaturgradient ausbildet und die Halbleiterschmelze, beginnend am Keimkristall nach oben hin, erstarrt und einen Halbleiter-Einkristall 11 bildet.

Erst wenn die Ankeimung bzw. das Anwachsen des aus der Halbleiterschmelze erstarrten Halbleiter-Einkristalls an den Keimkristall 5 abgeschlossen ist, oder vorzugsweise erst wenn die Erstarrungsfront 12 den Bereich des Übergangs vom konischen Abschnitt 3 zum zylindrischen Abschnitt 2 des Tiegels 1 im wesentlichen oder vollständig erreicht hat, wird der Behälter 6 mittels der Einrichtung 8 auf der Unterseite geöffnet, so daß der Dotierstoff 7 in den Tiegel fällt und sich in der Halbleiterschmelze 9 auflöst. Der Dotierstoff 7 wird in einer geeigneterweise festen Form zugegeben, die es erlaubt, daß er im wesentlichen, vorzugsweise vollständig in der zugegebenen Menge die Abdeckschmelze durchlaufen kann, um in die Halbleiterschmelze 9 eintreten zu können. Die Menge des auf diese Weise hinzugefügten Dotierstoffs wird so bemessen, daß sich in der Schmelze eine Dotierstoffkonzentration einstellt, die unter Berücksichtigung des effektiven Verteilungskoeffizienten zu einem Einbau des Dotierstoffs in den Einkristall in der gewünschten Konzentration führt. Dadurch kann die gewünschte Dotierstoffkonzentration im hergestellten Halbleiter-Einkristall und somit im später gefertigten Substratwafer eingestellt werden. Bei der Bemessung der Dotierstoffmenge ist die bereits in der Halbleiterschmelze vorhandene Konzentration des Dotierstoffs und die Größe des bereits erstarrten Anteils der Halbleiterschmelze zu berücksichtigen. Der Erstarrungsprozeß kann durch geeignete Ansteuerung der Heizelemente für eine Zeitdauer, die für ein Auflösen des Dotierstoffs in der Halbleiterschmelze und eine Homogenisierung derselbigen geeignet ist, angehalten werden. Danach wird die Kristallzüchtung bis zur vollständigen Erstarrung der Halbleiterschmelze fortgesetzt.

Der Zusatz des Dotierstoffes erst nach der Ankeimung bzw. dem Anwachsen an den Keimkristall, oder bevorzugt erst nach dem Abschluß der Erstarrung (größtenteils und vorzugsweise vollständig) im konischen Bereich des Tiegels vermeidet eine starke Unterkühlung der Halbleiterschmelze während des Anwachsens an den Keimkristall und der Erstarrung im konischen Bereich des Tiegels und vermindert dadurch die Wahrscheinlichkeit des Auftretens von Fehlkeimbildungen und Zwillingswachstum in diesen kritischen Abschnitten des Kristallzüchtungsprozesses. Außerdem verkürzt sich die Zeitdauer, die für die Oxidation des Dotierstoffs durch die Abdeckschmelze (Boroxidschmelze) zur Verfügung steht. Dadurch gelingt es, sogar bei hoher Dotierstoffkonzentration die Verunreinigung der Kristalle durch aus der Abdeckschmelze stammenden Verunreinigung (Bor) deutlich zu verringern. Zudem sind verbesserte kristallographische Eigenschaften sichergestellt, insbesondere das Vorliegen einer einzigen kristallographischen Orientierung ohne Fehlorientierungen oder Zwillingskristallbildungen. Darüberhinaus wird die Hallbeweglichkeit günstig beeinflußt. Bei im Vergleich zu durch herkömmliche Verfahren hergestellten Halbleiter-Einkristallen kann die Konzentration von unerwünschten Störstellen, wie die von Bor-Störstellen verringert werden.

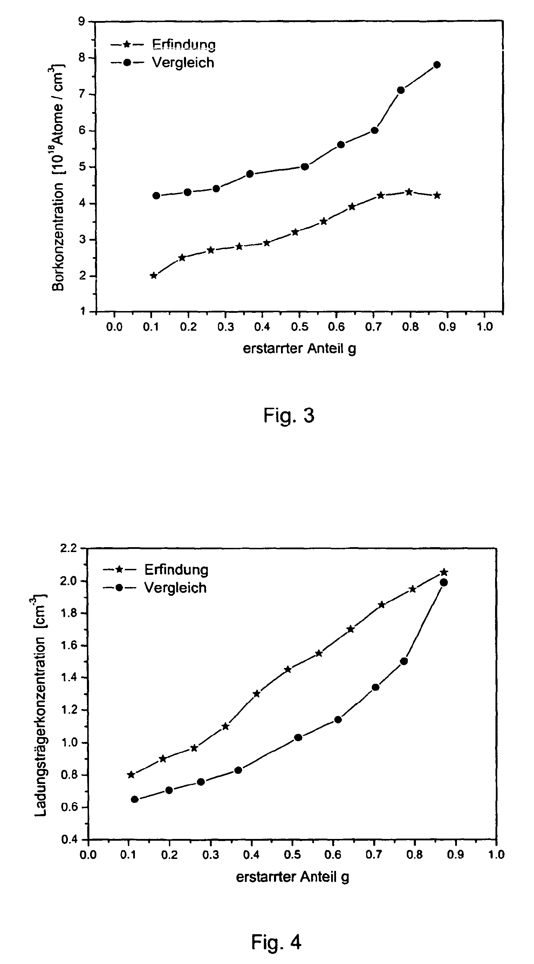

In Fig. 2 ist für das Beispiel eines Silizium-dotierten Galliumarsenid-Einkristalls, hergestellt nach dem beschriebenen Verfahren, der axiale Verlauf der Siliziumkonzentration, gemessen mittels ICP-AES (inductively coupled plasma atomic emission spectrometry), dargestellt. Ein Vergleich mit dem axialen Verlauf der Siliziumkonzentration in einem nach dem herkömmlichen Verfahren erzeugten Galliumarsenid-Einkristall zeigt, daß die prinzipielle Abhängigkeit der Siliziumkonzentration von der axialen Position im Kristall, ausgedrückt durch den erstarrten Anteil g, zwischen beiden Verfahren gleich ist. Die Siliziumkonzentration in dem nach dem hier beschriebenen Verfahren hergestellten Kristall beträgt jedoch an jeder axialen Position etwa das 2.5fache im Vergleich zur Konzentration in einem Kristall, der nach dem herkömmlichen Verfahren erzeugt wurde, ohne daß die einkristalline Ausbeute verringert wurde. Der erste Meßpunkt in Fig. 2 links sowie entsprechend in den weiteren Fig.3 - 6 bezieht sich auf den Anfang des zylindrischen Bereichs.

Fig. 3 zeigt einen dementsprechenden Vergleich der Konzentration der Borverunreinigung. Diese Konzentration kann durch das beschriebene Verfahren um den Faktor 2 - 3 gesenkt werden.

Fig. 4 zeigt einen dementsprechenden Vergleich des axialen Verlaufs der Ladungsträgerkonzentration. Die Ladungsträgerkonzentration konnte durch Anwendung des erfindungsgemäßen Verfahrens in dem gesamten Teilbereich des Kristalls, der für die Fertigung von Substratwafern verwendet wird, erhöht werden.

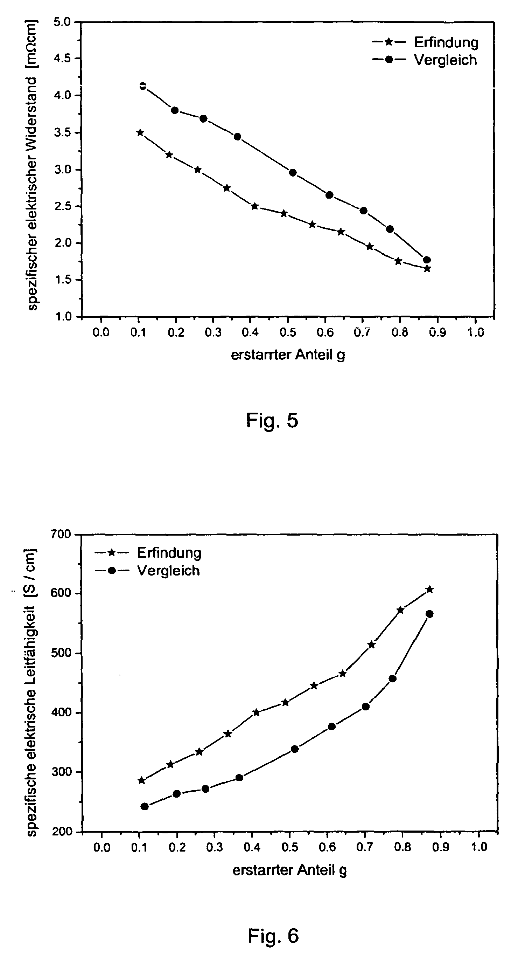

Wie Fig. 5 und Fig. 6 zeigen, ist im Vergleich zum herkömmlich hergestellten Halbleiter-Einkristall nur im erfindungsgemäßen Halbleiter-Einkristall, bezogen auf den jeweiligen Erstarrungspunkt im Kristall, ein relativ niedriger spezifischer elektrischer Widerstand mit einem relativ hohen spezifischen elektrischen Leitfähigkeit kombiniert. Der spezifische elektrische Widerstand und die spezifische elektrische Leitfähigkeit kann nach der Methode von van der Pauw (ASTM F76-86 "Standard Test Methods for Measuring Resistivity and Hall Coefficient and Determining Hall Mobility in Singie-Crystai Semiconductors") bestimmt werden.

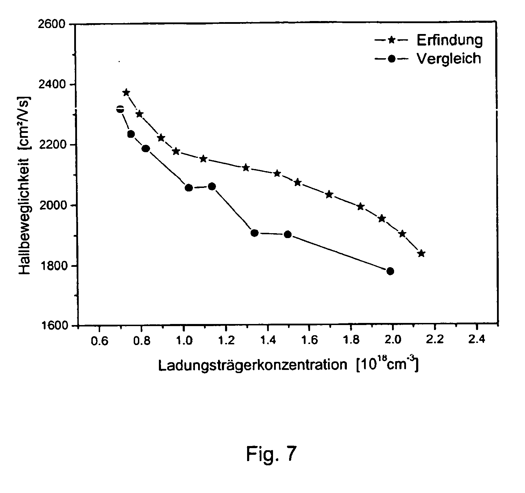

In Fig. 7 ist für das Beispiel eines Silizium-dotierten Galliumarsenid-Einkristalls mit großem Durchmesser (hier 100mm), hergestellt nach dem beschriebenen Verfahren, die Abhängigkeit der Hallbeweglichkeit von der mittels Hallmessung nach ASTM F76-86 "Standard Test Methods for Measuring Resistivity and Hall Coefficient and Determining Hall Mobility in Single-Crystal Semiconductors" ermittelten Ladungsträgerkonzentration aufgetragen. Durch die Reduzierung der Borverunreinigung wird die Konzentration an ionisierten Störstellen im Kristall vermindert. Da ionisierte Störstellen als Streuzentren für Ladungsträger fungieren, wird durch ihre Verminderung die Ladungsträgerbeweglichkeit erhöht.

Aus den im Rahmen der Erfindung erhaltenen Ergebnissen kann festgestellt werden, daß bei der Herstellung eines III-V-Halbleitereinkristalls mit einem Durchmesser von mindestens 100 mm, beruhend auf einer vertikal gerichteten Erstarrung einer Schmelze des Halbleitermaterials mit Kontakt zu einer z.B. Boroxid-haltigen Abdeckschmelze, im Gegensatz zum herkömmlichen Verfahren erst mittels der erfindungsgemäßen Technik in einem Bereich der Ladungsträgerkonzentration von mindestens 1,0 x 10¹⁸ cm⁻³ und insbesondere in einem Bereich der Ladungsträgerkonzentration von 1,0 x 10¹⁸ cm⁻³ bis 2,0 x 10¹⁸ cm⁻³, die erfindungsgemäß mit einer Konzentration eines Leitfähigkeit erzeugenden Dotierstoffs von mindestens 1×10¹⁸ Atome/cm³ erreichbar ist, die Hallbeweglichkeit mindestens 1900 cm²/Vs beträgt. Noch besser beträgt für den Fall einer Ladungsträgerkonzentration von 1,0 bis 1,2 x 10¹⁸ cm⁻³ die Hallbeweglichkeit mehr als 2100 cm²/Vs und für den Fall einer Ladungsträgerkonzentration von über 1,2 x 10¹⁸ cm⁻³, und insbesondere bis 2,0 x 10¹⁸ cm⁻³, mehr als 1900 cm²/Vs. In einem Bereich der Ladungsträgerkonzentration von 1,3 bis 1,8 x 10¹⁸ cm⁻³ beträgt die Hallbeweglichkeit sogar mindestens 2000 cm²/Vs.

Die Erfindung wird nachfolgend anhand eines Beispiels näher erläutert.

Für einen Vergleich zwischen dem herkömmlichen und dem erfindungsgemäßen Verfahren wurden zwei Tiegel aus pyrolytischem Bornitrid (pBN) mit einer wie in Fig. 1 schematisch dargestellten Form (Innendurchmesser ca. 102mm, Gesamtlänge ca. 230 mm) jeweils mit einem kompakten Körper aus undotiertem Galliumarsenid mit einer Masse von 11 kg befüllt. Für die Ausbildung einer Abdeckschmelze wurde je ein zylindrischer Boroxid-Körper mit einer Masse von 650 g in die Tiegel zugegeben. In den ersten Tiegel wurden als Dotierstoff 3.18 g Silizium in fester Form zugegeben. Diese Menge wurde so bemessen, daß sich nach dem Aufschmelzen und dem Durchführen der Erstarrung der Schmelze am Übergang zwischen dem konischen und dem zylindrischen Bereich des Galliumarsenid-Einkristalls eine Siliziumkonzentration von etwa 2 × 10¹⁸ cm⁻³ einstellt. In den zweiten Tiegel wurden nur 0.95 g Silizium, d.h. etwa 30% dieser Menge zugegeben. Der erste Tiegel wurden in einem Ofen erhitzt, bis das zu Beginn feste Galliumarsenid und das Boroxid aufgeschmolzen waren. Durch geeignete Ansteuerung der Heizelemente des Ofens wurde ein vertikaler Temperaturgradient erzeugt. Durch Verschiebung des Temperaturfeldes parallel zur Längsachse des Tiegels wurde die Schmelze beginnend am Keimkristall vollständig erstarrt. Der zweite Tiegel wurde in einem Ofen, der mit einem Behälter 6 und einer Einrichtung 8 zum nachträglichen Zugeben von Dotierstoff in den Tiegel nach Fig. 1 ausgestattet war, ebenfalls erhitzt, bis Galliumarsenid und Boroxid aufgeschmolzen waren. In den Behälter 6 war zuvor ein Menge von 1.95 g Silizium in fester Form gegeben worden. Die Erstarrung der Schmelze wurde danach soweit durchgeführt, bis die Erstarrungsfront den Bereich des Übergangs vom konischen zum zylindrischen Teil des Tiegels erreicht hatte. Danach wurde der Behälter 6 mittels der Einrichtung 8 geöffnet, worauf das Silizium in den Tiegel fiel. Anschließend wurde die Erstarrung der Schmelze fortgesetzt.
Die zylindrischen Abschnitte beider Kristalle wurden zu Wafern mit jeweils ca. 100 mm Durchmesser aufgearbeitet. Von dem nach dem herkömmlichen Verfahren hergestellten Kristall wurden neun Vergleichswafer und von dem nach dem erfindungsgemäßen Verfahren hergestellten Kristall wurden elf erfindungsgemäße Wafer ausgewählt, jeweils verteilt über verschiedene erstarrte Anteile g des Kristall-Ingots. An diesen Wafern wurde der spezifische elektrische Widerstand, die Hallbeweglichkeit und die Ladungsträgerkonzentration mittels van-der-Pauw- und Hallmessung nach ASTM F76-86 "Standard Test Methods for Measuring Resistivity and Hall Coefficient and Determining Hall Mobility in Single-Crystal Semiconductors" und die Gehalte an Silizium und Bor mittels ICP-AES bestimmt. Einstellungen bei der experimentellen Hallmessung nach ASTM F76-86:
- Probenform: quadratisches Plättchen aus dem Waferzentrum; laterale Abmessungen: 17 mm × 17 mm; Dicke 625 µm entsprechend der Waferdicke
- Probentemperatur während der Messung: (22 ± 0.2) °C
- Flußdichte des Magnetfelds: 0.47 T
- Probenstrom: 100 mA.
Die erhaltenen Meßdaten sind in Fig. 2-7 dargestellt. Die axiale Position der untersuchten Wafer ist jeweils durch den während des Kristallzüchtungsprozesses an dieser Position erstarrten Anteil g der Galliumarsenidschmelze angegeben.

Wie man aus Fig. 2 ersehen kann, ist die Siliziumkonzentration in jedem Wafer des nach dem hier beschriebenen Verfahren hergestellten Kristalls um etwa das 2.5fache höher als in einem Wafer an der entsprechenden axialen Position des nach dem herkömmlichen Verfahren hergestellten Kristalls, obwohl die gesamte zugegebene Menge an Dotierstoff für beide Kristalle annähernd gleich, genau genommen bei der erfindungsgemäßen Probe sogar etwas niedriger war. Die höhere Siliziumkonzentration führt zu einer höheren Ladungsträgerkonzentration (siehe Fig. 4), zu einem geringeren spezifischen elektrischen Widerstand (siehe Fig. 5) und zu einer höheren elektrischen Leitfähigkeit (siehe Fig. 6) des erfindungsgemäßen Kristalls bzw. Wafers. Fig. 3 zeigt, daß der Borgehalt trotz im Kristall erzielter höherer Silizuimkonzentration um einen Faktor von 2 - 3 gesenkt werden konnte. Aufgrund der dadurch verringerten Konzentration kompensierender Defekte wurde die Hallbeweglichkeit erfindungsgemäß signifikant erhöht (siehe Fig. 7).

Eine Erhöhung der Hallbeweglichkeit ist bei den erfindungsgemäßen Wafern mit relativ großem Durchmesser insbesondere in einem erwünschten Ladungsträgerkonzentrationsbereich von über 1 x 10¹⁸ cm⁻³ und insbesondere im Bereich von 1,0 x 10¹⁸ cm⁻³ bis 2,0 x 10¹⁸ cm⁻³ von großem Nutzen, weil in diesem Bereich der Ladungsträgerkonzentration, die erfindungsgemäß mit einer Konzentration eines Leitfähigkeit erzeugenden Dotierstoffs von mindestens 1×10¹⁸ Atome/cm³ und besser mindestens 1,5×10¹⁸ Atome/cm³ erreichbar ist, die Hallbeweglichkeit immer mindestens 1900 cm²/Vs beträgt. Noch besser beträgt für einen Fall einer Ladungsträgerkonzentration von 1,0 bis 1,2 x 10¹⁸ cm⁻³ die Hallbeweglichkeit mehr als 2100 cm²/Vs, und für einen Fall einer Ladungsträgerkonzentration von über 1,2 x 10¹⁸ cm⁻³, insbesondere im Bereich von 1,3 x 10¹⁸ cm⁻³ bis 1,8 x 10¹⁸ cm⁻³, mehr als 1900 cm²/Vs und sogar mindestens 2000 cm²/Vs.
Bei den Vergleichswafern werden diese Bedingungen des Verhältnisses von Hallbeweglichkeit zu Ladungsträgerkonzentration nicht eingehalten.

## Patentansprüche

1. Verfahren zur Herstellung eines mit einem Dotierstoff dotierten Halbleiter-Einkristalls durch Erstarrung einer Halbleiterschmelze in einem Tiegel, unter Verwendung eines Keimkristalls aus dem gleichen Halbleitermaterial wie der herzustellende Halbleiter-Einkristall, wobei das Verfahren auf der Basis einer vertikal gerichteten Erstarrung, unter Verwendung einer Abdeckschmelze (10), durchgeführt wird, **dadurch gekennzeichnet,**
**daß** die Menge des Dotierstoffs (7), die zur Einstellung einer gewünschten elektrischen Leitfähigkeit im erzeugten Halbleiter-Einkristall (11) gewählt wird,
(a) nach dem Anwachsen des gebildeten Halbleiter-Einkristalls (11) an den Keimkristall (5),
(b) oder nach dem Abschluß der Erstarrung des Halbleiter-Einkristalls (11) zu einem Großteil und vorzugsweise vollständig im konischen Bereich (3) des Tiegels (1)
in die Halbleiterschmelze (9) zugegeben wird,
oder daß die besagte Menge des Dotierstoffs (7) in mindestens zwei Stufen eingebracht wird, einschließlich einer ersten Stufe des Einbringens einer Teilmenge der besagten Menge vorab, d.h. vor (a) oder (b), in den Tiegel und einer zweiten Stufe der Zugabe einer verbleibenden Menge der besagten Menge gemäß (a) oder (b) in die Halbleiterschmelze (9).

2. Verfahren nach Anspruch 1, **dadurch gekennzeichnet, daß** beim mehrstufigen Prozeß im ersten Schritt die vorab, d.h. vor (a) oder (b) zugegebene Teilmenge des Dotierstoffs bis maximal 2/3tel, vorzugsweise im Bereich von 1/10tel bis 1/2 der Menge des Dotierstoffs (7) entspricht, die zur Einstellung der gewünschten elektrischen Leitfähigkeit im erzeugten Halbleiter-Einkristall (11) gewählt wird.

3. Verfahren nach Anspruch 1 oder 2, **dadurch gekennzeichnet, daß** die Konzentration des Dotierstoffs im gesamten konischen Teil (3) des hergestellten Halbleiter-Einkristalls (11) höchstens 1×10¹⁸ Atome/cm³ , bevorzugt höchstens 6×10¹⁷ Atome/cm³, beträgt,
und/oder daß die Konzentration des Dotierstoffs im gesamten zylindrischen Teil (2) des hergestellten Halbleiter-Einkristalls (11), gegebenenfalls im daraus gefertigten Substratwafer, mehr als 6×10¹⁷ Atome/cm³, bevorzugt mehr als 1×10¹⁸ Atome/cm³, beträgt.

4. Verfahren nach einem der vorangehenden Ansprüche, **dadurch gekennzeichnet, daß** die Konzentration von aus der Abdeckschmelze stammender Verunreinigung im gesamten zylindrischen Teil des hergestellten Halbleiter-Einkristalls (11), gegebenenfalls im daraus gefertigten Substratwafer , unterhalb von 5×10¹⁸ Atome/cm³ liegt.

5. Verfahren nach Anspruch 1, **dadurch gekennzeichnet, daß** die Abdeckschmelze (10) eine Boroxidschmelze ist und die daraus stammende Verunreinigung Bor ist.

6. Verfahren nach einem der vorangehenden Ansprüche, **dadurch gekennzeichnet, daß** der hergestellte Halbleitereinkristall ein Einkristall eines Verbindungshalbleiters, vorzugsweise eines III-V-Verbindungshalbleiters, ist.

7. Verfahren nach Anspruch 6, **dadurch gekennzeichnet, daß** der hergestellte Einkristall Galliumarsenid als Hauptbestandteil umfasst.

8. Verfahren nach einem der vorangehenden Ansprüche, **dadurch gekennzeichnet, daß** der hergestellte Halbleiter-Einkristall (11), gegebenenfalls ein daraus gefertigter Substratwafer, eine hohe elektrische Leitfähigkeit vom n- oder p-Typ aufweist, wobei eine elektrische Leitfähigkeit vom n-Typ bevorzugt wird.

9. Verfahren nach Anspruch 8, **dadurch gekennzeichnet, daß** der hergestellte Halbleiter-Einkristall (11), gegebenenfalls ein daraus gefertigter Substratwafer, eine elektrische Leitfähigkeit von mindestens 250 Siemens/cm und/oder einen spezifischen elektrischen Widerstand von höchstens 4×10⁻³ Ωcm aufweist.

10. Verfahren nach einem der vorangehenden Ansprüche, **dadurch gekennzeichnet, daß** die Zugabe des Dotierstoffs mit festem Dotierstoff (7) erfolgt.

11. Verfahren nach einem der vorangehenden Ansprüche, **dadurch gekennzeichnet, daß** als Dotierstoff Silizium in elementarer oder chemisch gebundener Form verwendet wird.

12. Verfahren nach einem der vorangehenden Ansprüche, **dadurch gekennzeichnet, daß** es nach einem VGF- oder VB-Verfahren durchgeführt wird.

13. III-V-Halbleiter-Einkristall-Ingot vom n-Typ mit:
- einer Konzentration eines Leitfähigkeit erzeugenden Dotierstoffs von mindestens 1×10¹⁸ Atome/cm³ und
- einer Konzentration einer herstellungsbedingt vorliegenden Verunreinigung von höchstens 5×10¹⁸ Atome/cm³,
wobei der III-V-Halbleiter-Einkristall eine elektrische Leitfähigkeit von mindestens 250 Siemens/cm und/oder einen spezifischen elektrischen Widerstand von höchstens 4×10⁻³ Ωcm aufweist,
wobei die angegebenen Bedingungen im gesamten zylindrischen Bereich des III-V-Halbleiter-Einkristall-Ingots vorliegen.

14. III-V-Halbleiter-Einkristall-Ingot gemäß Anspruch 13, **dadurch gekennzeichnet,**
- **daß** die Konzentration des Leitfähigkeit erzeugenden Dotierstoffs im Bereich von 1×10¹⁸ Atome/cm³ bis 5×10¹⁹ Atome/cm³, vorzugsweise im Bereich von 2×10¹⁸ Atome/cm³ bis 1×10¹⁹ Atome/cm³, liegt, und/oder
- **daß** die Konzentration einer herstellungsbedingt vorliegenden Verunreinigung im Bereich von 1×10¹⁷ Atome/cm³ bis 5×10¹⁸ Atome/cm³, vorzugsweise im Bereich von 1×10¹⁷ Atome/cm³ bis 3.5×10¹⁸ Atome/cm³, liegt.

15. III-V-Halbleiter-Einkristall-Ingot gemäß Anspruch 13 oder 14, **dadurch gekennzeichnet, daß** er nach einem VGF- oder VB-Verfahren mit Abdeckschmelze hergestellt wurde.

16. III-V-Halbleiter-Einkristall-Ingot gemäß Anspruch 13 oder 14, erhältlich nach einem der in den Ansprüchen 1 bis 11 definierten Verfahren.

17. III-V-Halbleiter-Einkristall-Ingot gemäß Anspruch 13 mit einem Durchmesser von mindestens 100 mm,
wobei in dem Anteil des zylindrischen Bereiches des Halbleitereinkristalls, in dem eine Ladungsträgerkonzentration von mindestens 1,0 x 10¹⁸ cm⁻³ vorliegt, die Hallbeweglichkeit, bestimmt nach ASTM F76-86, für den Fall einer Ladungsträgerkonzentration von 1,0 bis 1,2 x 10¹⁸ cm⁻³ mehr als 2100 cm²/Vs beträgt und für den Fall einer Ladungsträgerkonzentration von über 1,2 x 10¹⁸ cm⁻³, insbesondere im Bereich bis 2,0 x 10¹⁸ cm⁻³, mehr als 1900 cm²/Vs beträgt.

18. III-V-Halbleiter-Einkristall-Ingot gemäß Anspruch 17, wobei im Bereich einer Ladungsträgerkonzentration von 1,3 bis 1,8 x 10¹⁸ cm⁻³ die Hallbeweglichkeit mindestens 2000 cm²/Vs beträgt.

19. III-V-Halbleiter-Einkristall-Ingot gemäß Anspruch 17 oder 18, **dadurch gekennzeichnet, daß** die Konzentration eines Leitfähigkeit erzeugenden Dotierstoffs mindestens 1,5×10¹⁸ Atome/cm³ beträgt, und/oder daß eine Konzentration einer herstellungsbedingt vorliegenden Verunreinigung von höchstens 5×10¹⁸ Atome/cm³ enthalten ist.

20. III-V-Halbleiter-Einkristall-Ingot gemäß einem der Ansprüche 13 bis 19, **dadurch gekennzeichnet, daß** der die Leitfähigkeit erzeugende Dotierstoff Silizium ist, und/oder daß eine herstellungsbedingt vorliegende Verunreinigung Bor ist.

21. III-V-Halbleiter-Einkristall-Ingot gemäß einem der Ansprüche 13 bis 20, **dadurch gekennzeichnet, daß** die III-V-Halbleiterverbindung GaAs ist.

22. Substratwafer, gebildet aus einem III-V-Halbleiter-Einkristall-Ingot gemäß einem der Ansprüche 13 bis 21, bei denen die definierten Bedingungen entsprechend in allen aus dem zylindrischen Anteil des III-V-Halbleiter-Einkristall-Ingot hergestellten Substratwafern vorliegen.

## Claims

1. A process for preparing a semiconductor single crystal doped with a dopant, by solidifying a semiconductor melt in a crucible, using a seed crystal of the same semiconductor material as the semiconductor single crystal to be prepared, wherein the process is performed based on a vertically directed solidification, using a cover melt (10),
**characterised in that** the amount of the dopant (7), which is selected for setting the desired electrical conductivity in the produced semiconductor single crystal (11), is added to the semiconductor melt (9)
(a) after the formed semiconductor single crystal (11) has started to grow on the seed crystal (5),
(b) or after solidification of the semiconductor single crystal (11) has ended for the most part and preferably completely in the conical part (3) of the crucible (1),
or that said amount of the dopant (7) is added in at least two stages, including a first stage of adding a part of said amount to the crucible in advance, i.e. prior to (a) or (b), and a second stage of adding a residual portion of said amount to the semiconductor melt (9) according to (a) or (b).

2. The process according to claim 1, **characterised in that** in the multi-stage process in the first stage the part of the amount of the dopant added in advance, i.e. prior to (a) or (b), corresponds to at most 2/3, preferably in the range of 1/10 to 1/2 of the amount of the dopant (7), which is selected for setting the desired electrical conductivity in the produced semiconductor single crystal (11).

3. The process according to claim 1 or 2, **characterised in that** the concentration of the dopant in the whole conical part (3) of the produced semiconductor single crystal (11) is at most 1×10¹⁸ atoms/cm³, preferably at most 6×10¹⁷ atoms/cm³, and/or that the concentration of the dopant in the whole cylindrical part (2) of the produced semiconductor single crystal (11), optionally in the substrate wafer produced thereof, is more than 6×10¹⁷ atoms/cm³, preferably more than 1×10¹⁸ atoms/cm³.

4. The process according to one of the preceding claims, **characterised in that** the concentration of impurity derived from the cover melt is below 5×10¹⁸ atoms/cm³ in the whole cylindrical part of the produced semiconductor single crystal (11), optionally in the substrate wafer produced thereof.

5. The process according to claim 1, **characterised in that** the cover melt (10) is a boron oxide melt and the impurity derived therefrom is boron.

6. The process according to one of the preceding claims, **characterised in that** the produced semiconductor single crystal is a single crystal of a compound semiconductor, preferably of a III-V-compound semiconductor.

7. The process according to claim 6, **characterised in that** the produced single crystal comprises gallium arsenide as the main component.

8. The process according to one of the preceding claims, **characterised in that** the produced semiconductor single crystal (11), optionally a substrate wafer produced thereof, has a high electrical conductivity of n-type or p-type, wherein an electrical conductivity of n-type is preferred.

9. The process according to claim 8, **characterised in that** the produced semiconductor single crystal (11), optionally a substrate wafer produced thereof, has an electrical conductivity of at least 250 siemens/cm and/or an electrical resistivity of at most 4×10⁻³ Ωcm.

10. The process according to one of the preceding claims, **characterised in that** the addition of the dopant is carried out using solid dopant (7).

11. The process according to one of the preceding claims, **characterised in that** silicon in elemental or chemically bound form is used as dopant.

12. The process according to one of the preceding claims, **characterised in that** it is performed according to a VGF or VB process.

13. A III-V semiconductor single crystal ingot of n-type having:
- a concentration of a conductivity-generating dopant of at least 1×10¹⁸ atoms/cm³ and
- a concentration of an impurity, obtained due to the manufacturing process, of at most 5×10¹⁸ atoms/cm³,
wherein the III-V semiconductor single crystal has an electrical conductivity of at least 250 siemens/cm and/or an electrical resistivity of at most 4×10⁻³ Ωcm,
wherein the stated conditions are present in the whole cylindrical part of the III-V semiconductor single crystal ingot.

14. The III-V semiconductor single crystal ingot according to claim 13, **characterised in that**
- the concentration of the conductivity-generating dopant is in the range of 1×10¹⁸ atoms/cm³ to 5×10¹⁹ atoms/cm³, preferably in the range of 2×10¹⁸ atoms/cm³ to 1×10¹⁹ atoms/cm³, and/or
- the concentration of an impurity, obtained due to the manufacturing process, is in the range of 1×10¹⁷ atoms/cm³ to 5×10¹⁸ atoms/cm³, preferably in the range of 1×10¹⁷ atoms/cm³ to 3.5×10¹⁸ atoms/cm³.

15. The III-V semiconductor single crystal ingot according to claim 13 or 14, **characterised in that** it was produced according to a VGF or VB process with a cover melt.

16. The III-V semiconductor single crystal ingot according to claim 13 or 14, obtainable according to one of the processes defined in the claims 1 to 11.

17. The III-V semiconductor single crystal ingot according to claim 13 having a diameter of at least 100 mm,
wherein the Hall mobility, determined according to ASTM F76-86, in the fraction of the cylindrical part of the semiconductor single crystal having a charge carrier concentration of at least 1.0×10¹⁸ cm⁻³ is more than 2100 cm²/Vs in the case of a charge carrier concentration of 1.0 to 1.2×10¹⁸ cm⁻³, and more than 1900 cm²/Vs in the case of a charge carrier concentration of above 1.2×10¹⁸ cm⁻³, particularly in the range up to 2.0×10¹⁸ cm⁻³.

18. The III-V semiconductor single crystal ingot according to claim 17, wherein the Hall mobility is at least 2000 cm²/Vs in the range of a charge carrier concentration of 1.3 to 1.8×10¹⁸ cm⁻³.

19. The III-V semiconductor single crystal ingot according to claim 17 or 18, **characterised in that** the concentration of a conductivity-creating dopant is at least 1.5×10¹⁸ atoms/cm³, and/or that a concentration of an impurity, obtained due to the manufacturing process, of at most 5×10¹⁸ atoms/cm³ is contained.

20. The III-V semiconductor single crystal ingot according to one of the claims 13 to 19, **characterised in that** the conductivity-creating dopant is silicon, and/or that an impurity, obtained due to the manufacturing process, is boron.

21. The III-V semiconductor single crystal ingot according to one of the claims 13 to 20, **characterised in that** the III-V semiconductor compound is GaAs.

22. Substrate wafers, formed from a III-V semiconductor single crystal ingot according to one of the claims 13 to 21, having the defined conditions respectively in all substrate wafers produced from the cylindrical part of the III-V semiconductor single crystal ingot.

## Revendications

1. Procédé de production d'un monocristal semi-conducteur dopé avec un dopant par solidification d'une matière en fusion semi-conductrice dans un creuset, en utilisant un cristal germe issu de la même matière semi-conductrice que le monocristal semi-conducteur à produire, ledit procédé étant réalisé sur la base d'une solidification dirigée à la verticale, en utilisant une matière en fusion de recouvrement (10), **caractérisé en ce que**
la quantité de dopant (7), qui est choisie pour l'ajustement d'une conductivité électrique voulue dans le monocristal semi-conducteur (11) produit, est ajoutée à la matière en fusion semi-conductrice (9)
(a) après la croissance du monocristal semi-conducteur (11) formé sur le cristal germe (5),
(b) ou après l'achèvement de la solidification du monocristal semi-conducteur (11) en grande partie et de préférence en totalité dans la zone conique (3) du creuset (1)
ou **en ce que** ladite quantité de dopant (7) est introduite en au moins deux étapes, comprenant une première étape d'introduction d'une quantité partielle de ladite quantité au préalable, c'est-à-dire avant (a) ou (b), dans le creuset et une deuxième étape d'addition d'une quantité restante de ladite quantité selon le point (a) ou (b) dans la matière en fusion semi-conductrice (9).

2. Procédé selon la revendication 1, **caractérisé en ce que**, lors du procédé en plusieurs étapes, au cours de la première étape, la quantité partielle de dopant ajoutée au préalable, c'est-à-dire avant (a) ou (b), choisie pour l'ajustement de la conductivité électrique voulue dans le monocristal semi-conducteur (11) produit, correspond à au maximum 2/3 et de préférence à une plage allant de 1/10^{ème} et 1/2 de la quantité de dopant (7).

3. Procédé selon la revendication 1 ou 2, **caractérisé en ce que** la concentration en dopant dans toute la partie conique (3) du monocristal semi-conducteur (11) produit atteint au maximum 1 x 10¹⁸ atomes/cm³, de préférence au maximum 6 x 10¹⁷ atomes/cm³,
et/ou **en ce que** la concentration en dopant dans toute la partie cylindrique (2) du monocristal semi-conducteur (11) produit, le cas échéant dans la tranche de substrat qui en est fabriquée, est supérieure à 6 x 10¹⁷ atomes/cm³, de préférence supérieure à 1 x 10¹⁸ atomes/cm³.

4. Procédé selon l'une des revendications précédentes, **caractérisé en ce que** la concentration en impuretés provenant de la matière en fusion de recouvrement dans toute la partie cylindrique du monocristal semi-conducteur (11) produit, le cas échéant dans la tranche de substrat qui en est fabriquée, est inférieure à 5 x 10¹⁸ atomes/cm³.

5. Procédé selon la revendication 1, **caractérisé en ce que** la matière en fusion de recouvrement (10) est une matière en fusion d'oxyde de bore et l'impureté qui en provient est le bore.

6. Procédé selon l'une des revendications précédentes, **caractérisé en ce que** le monocristal semi-conducteur produit est un monocristal d'un semi-conducteur composite, de préférence d'un semi-conducteur composite III-V.

7. Procédé selon la revendication 6, **caractérisé en ce que** le monocristal produit comprend de l'arséniure de gallium comme composant principal.

8. Procédé selon l'une des revendications précédentes, **caractérisé en ce que** le monocristal semiconducteur (11) produit, le cas échéant une tranche de substrat qui en est fabriquée, présente une conductivité électrique élevée du type n ou p, la conductivité électrique de type n étant préférée.

9. Procédé selon la revendication 8, **caractérisé en ce que** le monocristal semi-conducteur (11) produit, le cas échéant une tranche de substrat qui en est fabriquée, présente une conductivité électrique d'au moins 250 Siemens/cm et/ou une résistance électrique spécifique d'au maximum 4 x 10⁻³ Ωcm.

10. Procédé selon l'une des revendications précédentes, **caractérisé en ce que** l'addition du dopant s'effectue avec un dopant solide (7).

11. Procédé selon l'une des revendications précédentes, **caractérisé en ce que** l'on utilise du silicium sous forme élémentaire ou lié chimiquement comme dopant.

12. Procédé selon l'une des revendications précédentes, **caractérisé en ce qu'**il est réalisé d'après une méthode VGF ou VB.

13. Lingot de monocristal semi-conducteur III-V de type n, comprenant :
- une concentration en un dopant, produisant la conductivité, d'au moins 1 x 10¹⁸ atomes/cm³ et
- une concentration en une impureté, présente du fait de la fabrication, d'au maximum 5 x 10¹⁸ atomes/cm³,
le monocristal semi-conducteur III-V présentant une conductivité électrique d'au moins 250 Siemens/cm et/ou une résistance électrique spécifique d'au maximum 4 x 10⁻³ Ωcm,
les conditions indiquées régnant dans toute la zone cylindrique du lingot de monocristal semi-conducteur III-V.

14. Lingot de monocristal semiconducteur III-V selon la revendication 13, **caractérisé en ce que**
- la concentration en dopant, produisant la conductivité, se situe dans la plage allant de 1 x 10¹⁸ atomes/cm³ à 5 x 10¹⁹ atomes/cm³, de préférence dans la plage allant de 2 x 10¹⁸ atomes/cm³ à 1 x 10¹⁹ atomes/cm³, et/ou
- la concentration en une impureté, présente du fait de la fabrication, se situe dans la plage allant de 1 x 10¹⁷ atomes/cm³ à 5 x 10¹⁸ atomes/cm³, de préférence dans la plage allant de 1 x 10¹⁷ atomes/cm³ à 3,5 x 10¹⁸ atomes/cm³.

15. Lingot de monocristal semi-conducteur III-V selon la revendication 13 ou 14, **caractérisé en ce qu'**il a été produit d'après une méthode VGF ou VB avec une matière en fusion de recouvrement.

16. Lingot de monocristal semi-conducteur III-V selon la revendication 13 ou 14, pouvant être obtenu d'après l'un des procédés définis dans les revendications 1 à 11.

17. Lingot de monocristal semi-conducteur III-V selon la revendication 13, ayant un diamètre d'au moins 100 mm,
la mobilité de Hall, déterminée d'après la norme ASTM F76-86, dépassant 2100 cm²/Vs dans le cas d'une concentration en porteurs de charge de 1,0 à 1,2 x 10¹⁸ cm⁻³, et dépassant 1900 cm²/Vs dans le cas d'une concentration en porteurs de charge de plus de 1,2 x 10¹⁸ cm⁻³, en particulier dans la plage allant jusqu'à 2,0 x 10¹⁸ cm⁻³, dans la partie de la zone cylindrique du monocristal semiconducteur dans laquelle il existe une concentration en porteurs de charge d'au moins 1,0 x 10¹⁸ cm⁻³.

18. Lingot de monocristal semi-conducteur III-V selon la revendication 17, la mobilité de Hall atteignant au moins 2000 cm²/Vs dans la zone d'une concentration en porteurs de charge 1,3 à 1,8 x 10¹⁸ cm⁻³.

19. Lingot de monocristal semi-conducteur III-V selon la revendication 17 ou 18, **caractérisé en ce que** la concentration en un dopant, produisant la conductivité, atteint au moins 1,5 x 10¹⁸ atomes/cm³, et/ou **en ce que** la concentration en une impureté, présente du fait de la fabrication, est d'au maximum 5 x 10¹⁸ atomes/cm³.

20. Lingot de monocristal semi-conducteur III-V selon l'une des revendications 13 à 19, **caractérisé en ce que** le dopant produisant la conductivité est le silicium et/ou **en ce qu'**une impureté présente du fait de la fabrication est le bore.

21. Lingot de monocristal semi-conducteur III-V selon l'une des revendications 13 à 20, **caractérisé en ce que** le composé du semi-conducteur III-V est GaAs.

22. Tranches de substrats, formées à partir d'un lingot de monocristal semi-conducteur III-V selon l'une des revendications 13 à 21, dans lesquelles les conditions définies règnent de manière correspondante dans toutes les tranches de substrats produites à partir de la partie cylindrique du lingot de monocristal semi-conducteur III-V.
